Europäisches Patentamt

European Patent Office

Office européen des brevets

(19)

(11) **EP 1 232 401 B1**

(12) **FASCICULE DE BREVET EUROPEEN**

(45) Date de publication et mention
de la délivrance du brevet:
**25.01.2006 Bulletin 2006/04**

(21) Numéro de dépôt: **00983379.9**

(22) Date de dépôt: **17.11.2000**

(51) Int Cl.:
*G01R 33/34* *(2006.01)*        *H01Q 21/24* *(2006.01)*

(86) Numéro de dépôt international:
**PCT/FR2000/003197**

(87) Numéro de publication internationale:
**WO 2001/036993 (25.05.2001 Gazette 2001/21)**

(54) **ANTENNE QUADRIPOLAIRE UTILISEE DANS UN SYSTEME RMN**

QUADRUPOL-ANTENNE ZUM GEBRAUCH IN EINEM NMR-SYSTEM

QUADRUPOLE ANTENNA FOR USE IN A NMR SYSTEM

(84) Etats contractants désignés:
**DE GB IT**

(30) Priorité: **19.11.1999 FR 9914564**

(43) Date de publication de la demande:
**21.08.2002 Bulletin 2002/34**

(73) Titulaire: **COMMISSARIAT A L'ENERGIE
ATOMIQUE
75752 Paris Cédex 15 (FR)**

(72) Inventeur: **LOCATELLI, Marcel
F-38330 Montbonnot (FR)**

(74) Mandataire: **Weber, Etienne Nicolas et al
c/o Brevatome,
3, rue du Docteur Lancereaux
75008 Paris (FR)**

(56) Documents cités:
DE-A- 4 024 598        US-A- 4 114 087
US-A- 5 280 249        US-A- 5 416 413

- LEE S.Y. ET AL: 'A Quadrature Excitation Coil for
  Open MRI System' PROCEEDINGS OF THE
  INTERNATIONAL SOCIETY FOR MAGNETIC
  RESONANCE IN MEDICINE, FOURTH SCIENTIFIC
  MEETING AND EXHIBITION vol. 3, 27 Avril 1996,
  NEW YORK, USA, page 1419, XP002189300
- GRANT D.M.; HARRIS R.K.: 'Encyclopedia of
  Nuclear Magnetic Resonance', 1996, JOHN
  WILEY & SONS, CHICHESTER * page 3133 - page
  3138 *

EP 1 232 401 B1

Printed by Jouve, 75001 PARIS (FR)

**Description**

**Domaine technique**

La présente invention concerne une antenne quadripolaire utilisée dans un système RMN de type "ouvert".

**Etat de la technique antérieure**

Les applications principales actuelles des dispositifs de mesure de résonance magnétique nucléaire ou RMN concernent les mesures de porosité dans le domaine pétrolier et tous les domaines tels que le domaine agro-alimentaire, le domaine du béton... où la quantité d'eau est une caractéristique importante.

Dans un dispositif RMN dit "ouvert", l'objet ou le circuit à caractériser se trouve à l'extérieur du volume du dispositif, contrairement par exemple aux imageurs médicaux pour lesquels le patient est situé à l'intérieur du système magnétique. Dans ce cas en particulier, les paramètres critiques des dispositifs RMN sont la puissance d'émission RF et le niveau de l'induction de polarisation produite par un système magnéto-statique.

La technique de mesure par RMN est bien connue pour détecter la présence de protons d'hydrogène. Cette technique est utilisée pour l'analyse de matière poreuse. Le principe consiste à visualiser les trous présents dans la matière, à les comptabiliser et à les soustraire du volume total.

L'amplitude du signal RMN émis par des protons qui ont été au préalable excités à partir d'un signal électromagnétique à la fréquence de résonance (fréquence définie par la valeur de l'induction magnétique de polarisation) est directement proportionnelle au moment magnétique des protons et donc à la quantité de ces protons. Une fois l'excitation supprimée, le système de protons retourne à son état initial avec des temps de relaxation dépendant de l'environnement. La mesure consiste à détecter l'évolution du signal dans le temps puis, par extrapolation, à en déduire la valeur à l'origine des temps. Cette valeur est proportionnelle à la quantité de protons excités.

Le principe de la RMN utilise les propriétés quantiques des protons. Un proton possède un moment cinétique intrinsèque, le spin $\vec{I}$. Or, soit $\gamma$ le rapport gyromagnétique du proton, ce moment cinétique est associé à un moment magnétique $\vec{m}$ par la formule :

$$\vec{m} = \gamma.\hbar.\vec{I}$$

Lorsque le proton est soumis à un champ magnétique intense $B_0$, il acquiert une vitesse de précession $\omega_0$ liée à l'induction $B_0$ par le facteur gyromagnétique $\gamma$ et son moment magnétique s'oriente dans la même direction. Deux états d'énergie quantifiés sont possibles : l'état parallèle $E^+$ (le plus stable) et l'état antiparallèle $E^-$. D'où les formules :

$$\omega_0 = \gamma.\,B_0 \qquad et \qquad \Delta E = E^+ - E^- = \hbar.\omega_0$$

Selon un traitement classique, il y a plus de noyaux précessant de façon parallèle que de façon antiparallèle. L'aimantation totale $\vec{M_0}$ résultant de tous les moments magnétiques des protons est donc colinéaire et de même sens que $\vec{B_0}$.

La RMN pulsée consiste à appliquer pendant une durée finie, un champ radiofréquence $\vec{B_1}$, appelé aussi impulsion, dans le plan perpendiculaire à $\vec{B_0}$. Pour réaliser une séquence RMN, plusieurs types d'impulsions sont utilisées. La première impulsion est appelée impulsion 90°. Son émission provoque un écartement de l'axe magnétique du proton de 90° par rapport à $\vec{B_0}$. Les protons sont en résonance et entrent en précession. Dans le cas d'une séquence dite CPMG, (Carr-Purcell-Meiboom-Gill), d'autres impulsions (appelées impulsions 180°) sont utilisées pour supprimer l'effet d'homogénéité incorrecte qui se traduit par une orientation disparate des spins des protons. Grâce aux impulsions 180°, les protons sont refocalisés (les spins ont la même phase), ce qui se traduit par la détection d'échos, dont la décroissance en amplitude dans le temps correspond à celle du signal d'un système homogène.

Chaque acquisition faite sur un écho d'un signal RMN est constituée de deux mesures réalisées en quadrature par détection synchrone. L'antenne réceptrice est une bobine située dans un plan orthogonal au champ magnétique $\vec{B}_0$. La valeur mesurée est constituée de composantes transversales Y et X (appelées aussi parties réelles Re et imaginaire Im) déphasées de 90° et elle caractérise la projection du champ magnétique $\vec{M}$ émis par les protons sur un plan orthogonal à $\vec{B}_0$. Les composantes réelles et imaginaires forment un signal complexe dont le module est celui de $\vec{M}$ projeté sur un plan perpendiculaire au champ $\vec{B}_0$. La partie imaginaire d'un écho ondule tandis que la partie réelle reste positive et présente un maximum au centre.

Un dispositif RMN est un système capable de réaliser une mesure RMN sur un échantillon et d'exploiter les données pour mettre en évidence les informations importantes (dans le cas présent, une quantité d'eau et des temps de relaxations). Il est conçu à partir de l'optimisation de différents sous-ensembles constituant le système : une sonde, une électronique composée d'un séquenceur, un récepteur et un émetteur, et un ordinateur qui contrôle l'acquisition et analyse les données. La sonde inclut un système statique, généralement constitué d'une source : bobinage ou aimant permanent et d'un circuit magnétique avec pièces polaires, et une antenne composée de bobinages et éventuellement de circuits magnétiques, qui du point de vue électrique, est définie à partir de sa self et de sa résistance. L'induction RF produite par l'antenne doit être perpendiculaire à l'induction statique dans le volume de mesure. Cette dernière étant radiale, la direction dé l'induction RF peut être horizontale ou verticale.

Pour améliorer l'efficacité de l'antenne, un champ tournant peut être produit à partir de deux champs de directions perpendiculaires et de modules égaux mais déphasés de $\pi/2$ dans le temps.

Le document Lee S.Y. et al, "A Quadrature Excitation RF Coil for Open MRI System", Proceedings of the International Society for Magnetic Resonance in Medicine, 1996, vol. 3, p. 1419 divulgue une antenne quadripolaire utilisée dans un système RMN ouvert apte à générer, dans une région de l'espace, un champ radiofréquence de module constant et tournant dans un plan (x-y), comportant deux éléments de base qui génèrent chacun dans ladite région un champ homogène de module égal et déphasé dans le temps de $\pi/2$ par rapport à l'autre, et de direction perpendiculaire à celui-ci, chaque élément de base étant formé de deux enroulements disposés dans un premier plan (x-y), et symétriquement par rapport à un second plan (z-x ou z-y), les plans de symétrie de chaque élément de base étant orthogonaux entre eux et orthogonaux au plan contenant le champ radiofréquence. Chaque enroulement est constitué d'au moins une spire.

Un document de l'art connu, le brevet US 5 719 499, décrit une antenne dans un dispositif permettant l'excitation et la détection d'une résonance magnétique, telle que la résonance magnétique nucléaire. Cette antenne quadripolaire comprend ainsi deux enroulements perpendiculaires et déphasés de $\pi/2$ permettant de commander l'amplitude et la phase de champs électromagnétiques orthogonaux.

L'invention a pour objet une telle antenne quadripolaire qui permette d'accroître l'efficacité du système d'émission radiofréquence.

**Exposé de l'invention**

La présente invention concerne une antenne quadripolaire pour un système RMN ouvert,apte à générer, dans une région de l'espace, un champ radiofréquence de module constant et tournant dans un plan, comportant deux éléments de base qui génèrent chacun dans ladite région un champ homogène de module égal et déphasé dans le temps de $\pi/2$ par rapport à l'autre et de direction perpendiculaire à celui-ci,

-   chaque élément de base étant formé de deux enroulements disposés symétriquement par rapport à un plan, et par un circuit magnétique qui est commun à tous les enroulements, les axes des enroulements étant disposés dans un même plan,
-   les plans de symétrie de chaque élément de base étant orthogonaux entre eux et orthogonaux au plan contenant le champ radiofréquence.

Avantageusement, cette antenne comprend des bobines de couplage des quatre enroulements à une électronique de commande.

**Brève description des dessins**

La figure 1 illustre une antenne quadripolaire de l'art connu.

Les figures 2A et 2B illustrent un élément de base d'une antenne respectivement dans une vue de face et une vue de profil.

Les figures 3A, 3B et 3C illustrent une antenne respectivement dans une vue de perspective, une vue de côté et une vue de dessus.

La figure 4 illustre une antenne en cas d'utilisation de boucles de couplages à une électronique de commande.

La figure 5 illustre un élément de base de l'antenne de l'invention.

La figure 6 illustre l'antenne de l'invention.

La figure 7 illustre l'antenne de l'invention, représentée sur la figure 6, en cas d'utilisation de boucles de couplage à une électronique de commande.

**Expose détaillé de modes de réalisation**

En RMN pulsée on applique, pendant une durée finie, un champ radiofréquence $\vec{B}_1$, appelé aussi impulsion dans le plan perpendiculaire à l'induction $\vec{B}_0$.

Les impulsions de commande permettent de contrôler la rotation du spin du proton soumis à ces champs $\vec{B}_0$ et $\vec{B}_1$.

Une antenne quadripolaire permet de générer un champ tournant $\vec{B}_1$.

L'angle de rotation du spin du proton est alors donné par la relation :

$$a = \gamma \cdot \vec{B}_1 \cdot dt$$

où $\gamma$ est le facteur gyromagnétique du proton considéré.

$B_1$ le module de l'induction tournante RF fourni par l'antenne quadripolaire interagissant de façon résonante avec le spin, lorsque la fréquence de rotation RF est égale à la fréquence de précession du proton $f_0 = \gamma . B_0$, où $B_0$ est le module de l'induction magnétique statique de polarisation des protons, ce module dépendant de l'efficacité de l'antenne $B_a/I_a$ où $B_a$ et $I_a$ correspondent respectivement au module de l'induction fournie par l'antenne d'émission parcourue par un courant $I_a$.

Dans le cas d'une antenne formée par un seul enroulement, $B_1$ est égal à la moitié de l'induction émise $B_a$ et de même la puissance utile est égale à la moitié de la puissance émise.

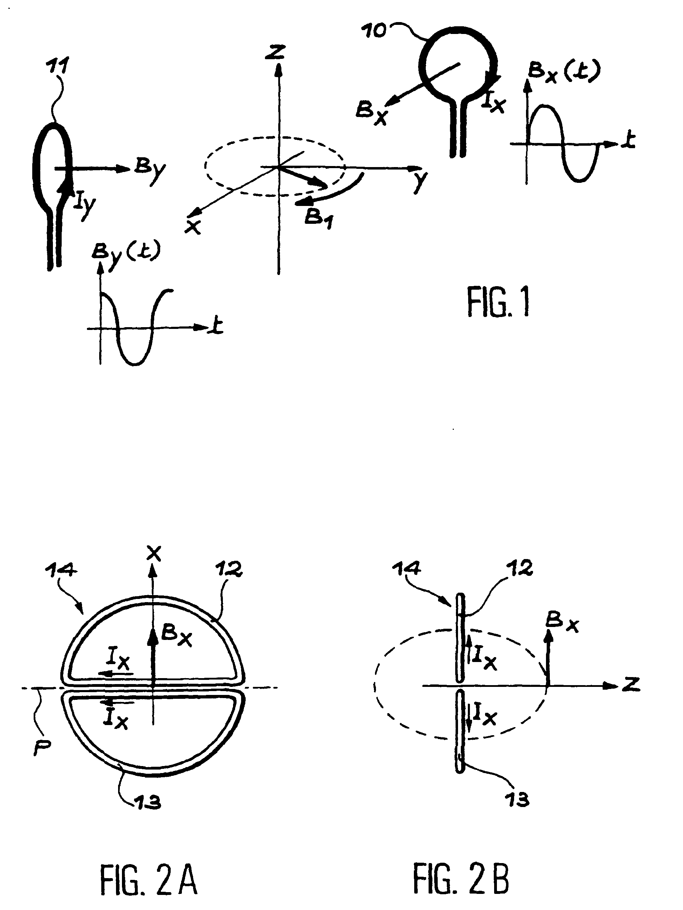

Afin de réduire cette perte d'efficacité et de puissance à l'émission, une solution de l'art connu comprend deux enroulements 10 et 11 de directions perpendiculaires, oscillants à la fréquence $f_0$ et déphasés dans le temps de $\pi/2$, comme illustré sur la figure 1. Une telle solution est utilisée dans le brevet US 5 719 499, cité précédemment. Sur cette figure sont représentés les inductions Bx(t) et By(t) ainsi que l'induction résultante $B_1$.

Une solution possible, met en oeuvre une telle technique dans le cas des antennes de surfaces utilisées en particulier dans les structures RMN ouvertes, le gain en puissance permettant en particulier d'accroître la profondeur de mesure. Elle concerne une antenne quadripolaire qui comporte deux éléments de base 14, tel que représenté sur les figures 2A et 2B, formé chacun de deux enroulements d'une ou plusieurs spires, tel que :

-   les enroulements 12 et 13 sont symétriques l'un de l'autre par rapport à un plan P,
-   les plans de symétrie P, (P') de chaque élément de base sont orthogonaux entre eux et orthogonaux au plan contenant le champ radiofréquence résultant $\vec{B}_1$,
-   chaque élément de base génère dans ladite région un champ $\vec{B}_x$, $\vec{B}_y$ homogène, de module égal et déphasé dans le temps de $\pi/2$ par rapport à l'autre et de direction perpendiculaire à celui-ci.

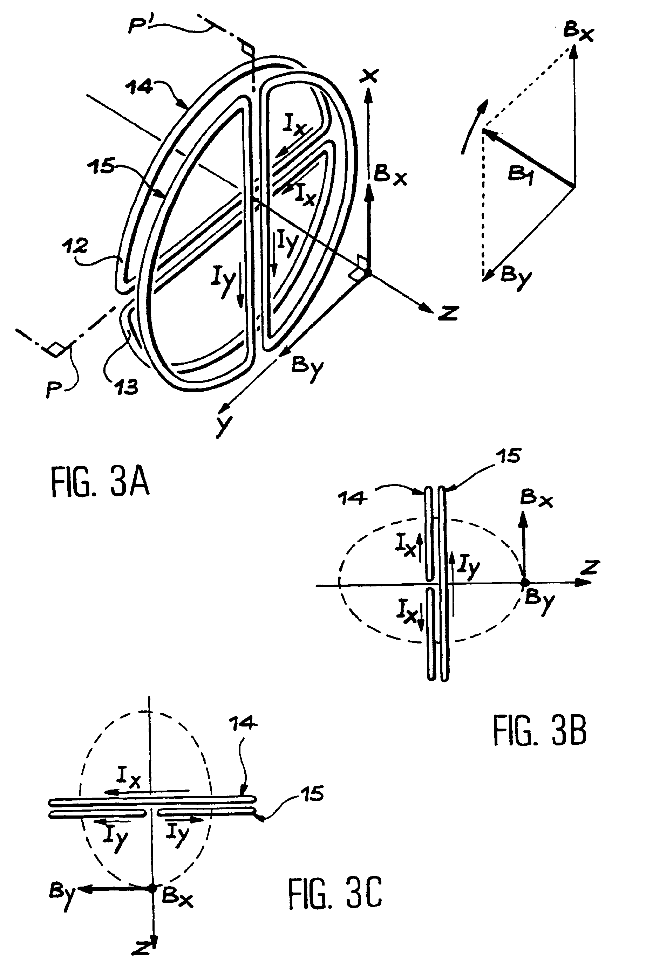

Cette antenne est constituée de deux tels éléments de base 14 et 15, comme illustré sur les figures 3A, 3B et 3C respectivement dans une vue en perspective, une vue de côté, et une vue de dessus ; le premier élément 14 correspondant à celui représenté sur les figures 2A et 2B. Pour une meilleure compréhension, une représentation des champs $\vec{B}_x$, $\vec{B}_y$ et du champ tournant résultant $\vec{B}_1$ a été illustrée sur le côté de la figure 3A.

Le second élément 15 est décalé par rapport au premier 14 pour faciliter la lisibilité. En réalité il est superposé à celui-ci.

Du fait de la circulation des courants Ix circulant dans le premier élément 14 et Iy circulant dans le second élément 15, le couplage mutuel entre les deux éléments de base est nul. Les flux se retranchent entre les éléments x et y.

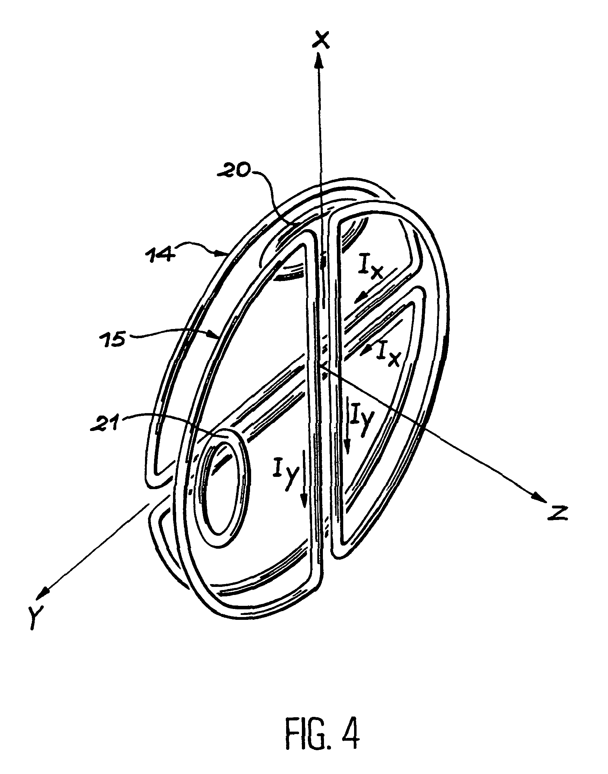

De même en cas d'utilisation de boucles de couplage 20 et 21 à une électronique de commande comme illustré sur la figure 4, celles-ci sont positionnées afin qu'un couplage existe uniquement avec l'élément de base correspondant. Ainsi la boucle de couplage 20 est en position symétrique par rapport à l'axe x, et la boucle de couplage 21 est en position symétrique par rapport à l'axe y. Sur cette figure les éléments 14 et 15 sont normalement superposés.

Ce type de structure est adapté aux systèmes où la zone de mesure est limitée par rapport aux dimensions de la structure, par exemple 1 cm comparé à 10.

Dans un exemple avantageux de réalisation, pour améliorer encore le rapport puissance émise/puissance nécessaire de l'antenne et donc d'améliorer la profondeur d'investigation de la sonde on utilise des spires dont le diamètre est de l'ordre de 6 cm, on obtient alors un champ d'environ $10^{-3}$ Tesla pour un courant d'environ 10 A dans les spires.

Toujours en vue de limiter la puissance RF l'invention utilise un circuit magnétique, ce qui permet de limiter l'énergie magnétique du fait de la matérialisation d'un espace à forte densité électromagnétique, par le circuit, et de plus, permet d'homogénéiser l'induction.

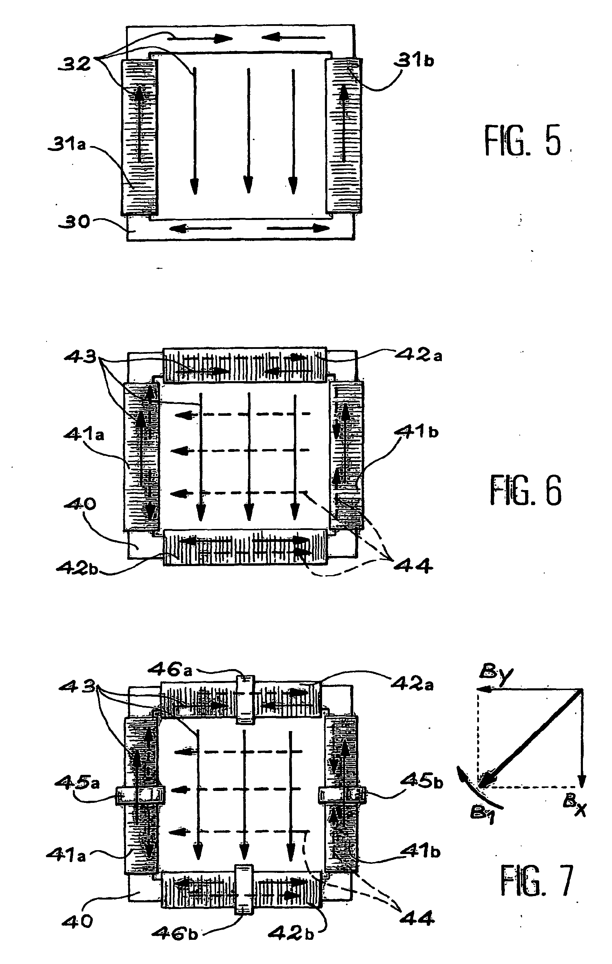

Un élément de base d'une telle réalisation, représenté sur la figure 5, comporte ainsi un circuit magnétique 30, deux bobines 31a et 31b, les lignes d'induction étant référencées 32.

L'antenne de l'invention forme alors une configuration quadripolaire, qui est illustrée sur la figure 6. Elle comprend ainsi un circuit magnétique 40, des bobines 41a et 41b fournissant les composantes en phase, des bobines 42a et 42b fournissant les composantes en quadrature, les lignes d'induction en phase et les lignes d'induction en quadrature étant respectivement référencées 43 et 44.

Dans le cas de l'utilisation de bobines 45a et 45b et 46a et 46b de couplage à une électronique de commande, comme illustré sur la figure 7, celles-ci sont placées dans la partie médiane de chaque branche du circuit ce qui permet de coupler les deux composantes en phase et en quadrature. Sur cette figure sont illustrées le circuit magnétique 40, les bobines 41a et 41b, les bobines 42a et 42b, les lignes d'induction en phase 43 et les lignes d'induction en quadrature 44 comme sur les figures 6A et 6B, ainsi que les bobines 45a et 45b de couplage avec les composantes en phase, et les bobines 46a et 46b de couplage avec les composantes en quadrature. Pour une meilleure compréhension de l'invention, une représentation des champs $\vec{B}_x$ $\vec{B}_y$ et du champ tournant résultant $\vec{B}_1$, a été illustrée sur le côté de la figure 7.

Dans un exemple de réalisation, afin d'améliorer encore le rapport puissance émise/puissance nécessaire de l'antenne et donc améliorer la profondeur d'investigation de la sonde, on utilise des bobines, entourant des barreaux de ferrite doux, formant un circuit magnétique carré d'environ 2 m de côté, le champ obtenu étant alors de l'ordre de $10^{-4}$ Tesla.

**Revendications**

1. Antenne quadripolaire pour un système RMN ouvert apte à générer, dans une région de l'espace, un champ radiofréquence ($\vec{B}_1$) de module constant et tournant dans un plan, comportant deux éléments de base qui génèrent chacun dans ladite région un champ homogène ($\vec{B}_x$, $\vec{B}_y$) de module égal et déphasé dans le temps de $\pi/2$ par rapport à l'autre, et de direction perpendiculaire à celui-ci,

   - chaque élément de base (41, 42) étant formé de deux enroulements (41a, 41b ; 42a, 42b) disposés symétriquement par rapport à un plan (P, P') et par un circuit magnétique (40) qui est commun à tous les enroulements, les axes des enroulements étant disposés dans un même plan,
   - les plans de symétrie (P,P') de chaque élément de base étant orthogonaux entre eux et orthogonaux au plan contenant le champ radiofréquence ($\vec{B}_1$).

2. Antenne selon la revendication 1, comprenant des bobines (45,46) de couplage des quatre enroulements (41a, 41b ; 42a, 42b) à une électronique de commande.

**Claims**

1. Four-pole aerial for a nuclear magnetic resonance system capable of generating within a region of the space a radio frequency field ($\vec{B_1}$) of constant modulus and rotating within a plane comprising two base elements (14, 15) which each generate in the said region a homogeneous field ($\vec{B_x}$, $\vec{B_y}$) of equal modulus and dephased over a period of time by $\pi/2$ compared to the other and in a direction perpendicular thereto:

   - each base element (41, 42) being formed of two windings (41a, 41b; 42a, 42b) arranged symmetrically with respect to a plane (P, P') and by a magnetic circuit (40) common to all the windings, the axes of the windings being located in the same plane,
   - the planes of symmetry (P, P') of each base element being orthogonal to one another and orthogonal to the plane containing the radio frequency field ($\vec{B_1}$).

2. Aerial according to claim 1, comprising coils (45, 46) for coupling four windings (41a, 41b; 42a, 42b) to an electronic control unit.

**Patentansprüche**

1. Quadrupol-Antenne für ein offenes NMR-System, fähig in einem Raumbereich ein sich in einer Ebene drehendes Hochfrequenzfeld ($\vec{B}_1$) mit konstantem Modul zu erzeugen, zwei Basiselemente umfassend, von denen jedes in dem genannten Bereiche ein homogenes Feld ($\vec{B}_x$, $\vec{B}_y$) mit gleichem Modul erzeugt, das eine in Bezug auf das andere zeitlich um $\pi/2$ Phasenverschoben und senkrecht zu diesem ausgerichtet,

   - wobei jedes Basiselement (41, 42) durch zwei Wicklungen (41a, 41b; 42a, 42b), symmetrisch angeordnet in Bezug auf eine Ebene (P, P'), und durch einen gemeinsamen Magnetkreis (40) aller Wicklungen gebildet wird, wobei die Achsen der Wicklungen in einer selben Ebene angeordnet sind,
   - wobei die Symmetrieebenen (P, P') jedes Basiselements zueinander und zu der das Hochfrequenzfeld ($\vec{B}_1$) enthaltenden Ebene rechtwinklig sind.

2. Antenne nach Anspruch 1, Spulen (45, 46) zum Koppeln der vier Wicklungen (41 a, 41 b; 42a, 42b) mit einer Steuerelektronik umfassend.

FIG. 1

FIG. 2 A

FIG. 2 B

FIG. 3A

FIG. 3B

FIG. 3C

FIG. 4

FIG. 5

FIG. 6

FIG. 7